# EUROPÄISCHE PATENTSCHRIFT

(11) **EP 3 929 600 B1**
(45) Veröffentlichungstag und Bekanntmachung des Hinweises auf die Patenterteilung: **07.06.2023**
(21) Anmeldenummer: 21181381.1
(22) Anmeldetag: 24.06.2021
(51) Int. Cl.: G01R 31/12

(54) **VERFAHREN ZUR BREITBANDIGEN ULTRASCHALLDETEKTION ELEKTRISCHER ENTLADUNGEN**
METHOD FOR BROADBAND ULTRASONIC DETECTION OF ELECTRICAL DISCHARGES
PROCÉDÉ DE DÉTECTION PAR ULTRASONS LARGE BANDE DES DÉCHARGES ÉLECTRIQUES

(30) Priorität: 24.06.2020 DE 102020116622
(43) Veröffentlichungstag der Anmeldung: 29.12.2021
(73) Patentinhaber: Sonotec GmbH, 06112 Halle (Saale) (DE)
(72) Erfinder: HOLSTEIN, Peter, 04425 Taucha (DE); THARANDT, Andreas, 04205 Leipzig (DE); BADER, Nicki, 06120 Halle (Saale) (DE); MOECK, Steffen, 04129 Leipzig (DE); MÜNCH, Michael, 06110 Halle (Saale) (DE); SCHREIBER, Christian, 06110 Halle (Saale) (DE)
(74) Vertreter: Maikowski & Ninnemann Patentanwälte Partnerschaft mbB

(56) Entgegenhaltungen:
- EP-A2- 0 119 844
- CN-A- 109 490 730
- KR-B1- 101 318 926
- US-A1- 2011 252 888
- US-A1- 2016 341 782

## Beschreibung

Die Erfindung betrifft ein Verfahren zur Detektion und Bewertung von Ultraschallquellen mit einem breitbandigen Ultraschallmikrophon und mobilen Prüfsystem, wobei die Ultraschallquellen akustische Auswirkungen von Störstellen, insbesondere von elektrischen Teilentladungen darstellen, die sich durch Luftschall ausbreiten. Erfindungsgemäß wird ein breitbandiges Ultraschallsignal mindestens einer Ultraschallquelle gemessen und mindestens ein geeignet wählbarer Frequenzbereich des Ultraschallsignals ausgewertet. Die Auswahl des Frequenzbereichs, in dem das Ultraschallsignal ausgewertet wird, erfolgt in Abhängigkeit der verfügbaren Signalstärke, die von der Entfernung zwischen Ultraschallmikrophon und Ultraschallquelle abhängt. Weiterhin betrifft die Erfindung ein Ultraschallmessgerät, insbesondere ein Ultraschallprüfgerät und die Verwendung des erfindungsgemäßen Verfahrens oder des Ultraschallmessgerätes für die Detektion und Bewertung von elektrischen Störstellen.

Die Zuverlässigkeit elektrischer Systeme ist Grundlage für die Versorgung aller Bereich der Gesellschaft mit Energie. Ein wichtiger Teil der industriellen Instandhaltung ist deshalb auf die Sicherheit der Versorgung mit elektrischer Energie und des technischen Betriebs der Anlagen ausgerichtet. Zu den Zielen der vorbeugenden Instandhaltung elektrischer Anlagen gehört das Auffinden und das Bewerten sich entwickelnder Isolationsfehler, um geeignete Maßnahmen einleiten zu können. Typische Probleme treten an vielen Betriebsmitteln der Energieerzeugung, -Übertragung und -verteilung auf, z. B. in (Hochspannungs-) Kabeln, Schaltanlagen, E-Motoren, Generatoren und Transformatoren. Isolationsfehler können zu ernsthaften Folgeschäden und Ausfällen - bis hin zu katastrophalen Situationen - führen.

In Hochspannungsanlagen wie Hochspannungsfreileitungen, Umspanneinrichtungen, Schaltschränken, Trafoanlagen und anderen, gefährden unerwünschte elektrische Teilentladungen die Funktion und Sicherheit.

Es gibt verschiedene Mess- und Prüftechnologien, solche unerwünschten Teilentladungen nachzuweisen. Neben der Messung der dabei auftretenden elektrischen Felder bzw. induzierten Spannungen werden thermografische Verfahren und auf Ultraviolettstrahlung beruhende Verfahren eingesetzt. Aufgrund der mechanischen Wirkung elektrischer Funken sind auch akustische und Vibrationsmethoden prinzipiell für den Nachweis der Entstehung und der Lokalisierung geeignet.

Unterschieden werden dabei innere und äußere Teilentladungen.

Teilentladungen sind gemäß DIN EN 60270 festgelegt als "örtlich beschränkte elektrische Entladung, welche die Isolierung zwischen Leitern nur teilweise überbrückt und welche angrenzend an einen Leiter auftreten kann, aber nicht muss". Die für die Instandhaltung relevanten Teilentladungsphänomene lassen sich in bestimmte Typen eingruppieren wie z.B.:
Innere Teilentladungen:
   - Einschlüsse (Mikanit-Isolierung)
   - Treeing (Hochspannungskabel)
Äußere Teilentladungen:
   - Korona (Befestigungselemente, Freileitungen)
   - Gleitentladung (Isolatoren)

Innere Teilentladungen treten auf, wenn durch Inhomogenitäten in Materialien, bei Anliegen elektrischer Felder, hohe Feldstärken erzielt werden können. Aufgrund des Unterschiedes in der Dielektrizitätszahl kann es zu lokalen Spannungsüberschlägen kommen. Diese lokalen Entladungen sind gleichzeitig akustische Quellen. Die Ausbreitungen der Schallwellen erfolgt dann im Medium (Flüssigkeit, Festkörper, umgebende Konstruktion). Diese Phänomene werden durch Verfahren, die auf Vibration und/oder der Ausbreitung von Körperschall beruhen detektiert. Diese Phänomene sind nicht Gegenstand der vorliegenden Erfindung.

Bei luftisolierten elektrischen Betriebsmitteln und daran auftretenden äußeren Teilentladungsphänomenen werden die akustischen Auswirkungen von Entladungen als direkter oder indirekter Schall über die Ausbreitung in Luft weitergeleitet.

Der Nachweis der elektrischen Entladungen erfolgt in der Regel mit im Ultraschallbereich wirksamer Mess- und Prüftechnik. Hierfür stehen analoge und digitale Prüftechniklösungen zur Verfügung.

Meist werden auf analoger Basis arbeitende Heterodynempfänger eingesetzt, die über ein schmalbandiges Ultraschall-Mikrophon und über eine integrierte Mischer-Frequenz-Technik verfügen, die den in einem engen Frequenzband vorhandenen Ultraschall erfassen und bewerten kann. Physikalisch ist dieser Zugang nicht zwingend. Jedoch ist er relativ einfach und kostengünstig realisierbar. Die elementaren Prozesse bei der elektrischen Entladung laufen sehr schnell ab. Das bedeutet, dass - physikalisch gesehen - ein sehr breites akustisches Spektrum erzeugt wird.

Ein typischer Frequenzbereich bei der Erfassung liegt in praktischen Anwendungen um 40 kHz. Die Wahl dieser Frequenz hat pragmatische Gründe. Durch die Verwendung des Ultraschalls spielen Umgebungs- und Störgeräusche im hörbaren Bereich eine geringere Rolle als bei der Erfassung von Signalen im hörbaren Bereich. Weiterhin zeichnet sich Ultraschall dadurch aus, dass seine Ausbreitungsrichtung gut nachverfolgt werden kann und dadurch eine Quellenortung leichter als bei tieferen Frequenzen möglich ist. Es ist zum einen preiswerte Sensorik (Ultraschall-Abstandswarnung bei Fahrzeugen) vorhanden und zum anderen ist die Reichweite von Ultraschall bei 40 kHz noch groß genug, um praxisrelevante Anwendungsszenarien zu bedienen. Die Nachweistechnik wird dabei meist als tragbares Handprüfgerät ausgeführt. Zur Unterstützung der Lokalisierung der Quelle und zur physikalischen Verstärkung des Signals werden geeignete Hohlspiegel eingesetzt.

Die Einführung digitaler breitbandiger Prüftechnik ermöglicht die Nutzung des gesamten akustisch auftretenden Frequenzbereichs. Die Bewertung kann anhand geeigneter Anzeige und Aufzeichnung des Ultraschallsignals (Amplitudenverlauf, Spektrogramme, Pegeldarstellungen) vorgenommen werden. Eine digitale Nachbildung der analogen Schmalbandverfahren ist dabei ebenfalls möglich. Ein wichtiges Element der Realisierung auf Basis breitbandiger Ultraschalltechnologie ist die komplette Digitalisierung der gesamten Signalkette. Damit ist auch die Integration und Optimierung von Algorithmen der Signalverarbeitung möglich.

Die Ausbreitung von Schall in Luft unterliegt bekanntermaßen einer frequenzabhängigen Dämpfung. Als Alltagserfahrung ist gegenwärtig, dass der Blitze begleitende Donner z. T. nur bei niederen Frequenzen hörbar ist. Die bei der Entladung auftretenden höheren Frequenzen werden über größere Entfernungen von der Luft absorbiert. Dieser Effekt ist auch bei Entfernung wirksam, wie sie bei der Überprüfung elektrischer Entladungen üblich sind (einige Meter bis 10 m).

Die Dämpfung in Luft hängt von der Entfernung, der Temperatur und der Feuchtigkeit ab. Der Druckeinfluss kann vernachlässigt werden. Die Ausbreitung von Schall im Freien wird in der DIN ISO 9613 (Dämpfung des Schalls bei der Ausbreitung im Freien) beschrieben. Dort sind die diesbezüglichen Dämpfungskoeffizienten in nachvollziehbarer Form angegeben. Eine exakte analytische Beschreibung ist aufgrund der Vielzahl von Parametern während einer Prüfung von Entladungsvorgängen nicht möglich. Dies ist aber auch aufgrund der bei der Prüfung erreichbaren und geforderten Genauigkeit nicht erforderlich. Eine Prognose aufgrund der Prüfsituation ohne weitere Maßnahmen würde auf eine grobe Schätzung hinauslaufen.

Bei den Verfahren, die den Stand der Technik widerspiegeln, hängt die Bewertung von Ultraschallquellen mehr oder weniger zufällig von der Prüfentfernung ab. Die eingestellte Messfrequenz (z.B. 40 kHz) ist nur zufällig geeignet. Wenn man die Entfernungen vergrößert, verringern sich die Amplituden der höheren Frequenzen und die Charakteristik des Ultraschallsignals ist unter Umständen in dem verwendeten Messbereich nicht mehr detektierbar. Die Verfahren aus dem Stand der Technik sind daher nicht geeignet, elektrische Störungen sowohl aus kleineren wie auch aus größeren Entfernungen zu untersuchen und die Intensitäten zu vergleichen. Die digitalen breitbandigen Ultraschalldaten enthalten immer für jede Messentfernung ein von der Entfernungsdämpfung beeinflusstes Spektrum.

Darüber hinaus erfolgt keine automatische Bewertung der Mess- und Prüfdaten durch die bisher bekannten Lösungen. Die Bewertung muss der Nutzer/Prüfer anhand seines Erfahrungswissens durch Betrachtung der Messwerte auf einem Bildschirm oder Datenschriebs in einem Protokoll vornehmen oder anhand eines Höreindrucks. Insbesondere die Bewertung anhand des Höreindrucks ist sehr subjektiv geprägt und hängt stark von der Erfahrung des Prüfers ab.

Weiterhin können durch die Nutzung der analogen Schmalbandfrequenztechnik nicht alle physikalisch möglichen Situationen erfasst werden, die auftreten können.

Die verfügbare digitale Prüftechnik dagegen, die Frequenzen bis etwa 100 kHz Bandbreite bewertet, kann nur Rohdaten liefern. Eine integrierte oder nachgeschaltete Bewertung ist nicht verfügbar.

Die physikalisch begründeten Spezifika elektrischer Entladungen werden in keiner der bekannten Lösungen berücksichtigt. Elektrische Entladungen sind ein transientes Phänomen, auf dessen Erfassung die Messtechnik und Software nicht optimal ausgelegt ist. Eine Unterscheidung von unterschiedlichen Entladungsmustern ist bisher nicht möglich und nicht vorgesehen.

Die US 2016/0341782 A1 betrifft eine Vorrichtung und ein Verfahren zur stationären Überwachung von Stromversorgungsgeräten. Hierbei werden Lichtbögen auf der Grundlage von Ultraschall detektiert, indem ein oder mehrere Sensoren nahe eines Stromversorgungsgerätes positioniert und das Ultraschallsignal des Stromversorgungsgerätes aufgenommen wird. Aus den Daten wird ein Merkmalsvektor erzeugt, indem das Zeitsignal in den Frequenzraum überführt (per FFT) und in einzelne Intervalle zerlegt wird. Für jedes Intervall wird ein "frequency sub-band energy value" berechnet und normalisiert. Diese Werte stellen dann den Merkmalsvektor dar. Der Merkmalsvektor wird mit hinterlegten Merkmalsvektoren verglichen, die beim Auftreten von Lichtbögen detektiert worden sind. Zeigt dieser Vergleich eine hohe Ähnlichkeit wird ein Alarmsignal ausgegeben. Die US 2016/0341782 A1 offenbart keine Möglichkeit nicht-stationär in unterschiedlichen Entfernungen von einem zu prüfenden Gerät Prüfungen vorzunehmen. Es ist nicht vorgesehen entfernungsabhängige Messungen in irgendeiner Art umzusetzen. Entsprechend ist die Vorrichtung auch nicht als transportables Handgerät ausgebildet.

Die US 2011/0252888 A1 betrifft ein Ultraschallhandgerät, welches zur Überwachung der Funktionalität von Motorlagern oder Schaltschränken (auftreten von Lichtbögen) genutzt wird. Das Handgerät bietet die Möglichkeit das detektierte Ultraschallsignal mittels FFT im Frequenzraum darzustellen. Einem Prüfer steht damit die Möglichkeit zur Verfügung, ergänzend zu einem akustischen Signal, auch das Frequenzspektrum zu beurteilen. Das Handgerät weist weiterhin einen Laserpointer auf, mit dessen Hilfe der Abstand des Handgerätes zu einem zu untersuchenden Objekt ermittelt werden kann.

Die KR101 318 926 B1 offenbart ein Ultraschallmessgerät zur Detektion von Störstellen in elektrischen Energieversorgungsanlagen. Das Ultraschallmessgerät weist an der Vorderseite einen schmalbandigen Ultraschallsensor und an der Rückseite einen breitbandigen Ultraschallsensor auf.

Die CN 109 490 730 A betrifft ebenfalls ein Ultraschallmessgerät zur Detektion von Störstellen in elektrischen Energieversorgungsanlagen. Es wird ein Messgerät vorgeschlagen, mit dessen Hilfe unterschiedliche elektrische Entladungsarten auf Basis ihrer spektralen Muster erkannt werden sollen.

Der vorliegenden Erfindung liegt daher die Aufgabe zu Grunde, die akustische Auswirkung einer Teilentladung, die sich durch Luftschall ausbreitet, unter Berücksichtigung der Auswirkungen des Abstands des verwendeten Ultraschallmikrophons zur Ultraschallquelle zu detektieren und zu bewerten, beziehungsweise zu klassifizieren.

Hierfür stellt die Erfindung ein Verfahren zur Detektion und Bewertung von Ultraschallquellen mit einem breitbandigen Ultraschallmikrophon zur Verfügung, wobei die Ultraschallquellen akustische Auswirkungen einer elektrischen Teilentladung darstellen, die sich durch Luftschall ausbreiten, **dadurch gekennzeichnet, dass**
ein breitbandiges Ultraschallsignal mindestens einer Ultraschallquelle gemessen wird; mindestens ein Frequenzbereich des Ultraschallsignals ausgewertet wird;
und dass die Auswahl des Frequenzbereichs, in dem das Ultraschallsignal ausgewertet wird in Abhängigkeit von der Entfernung zwischen Ultraschallmikrophon und Ultraschallquelle erfolgt.

Darüber hinaus stellt die Erfindung ein Ultraschallmessgerät zur Detektion von breitbandigem Ultraschall zur Verfügung, aufweisend
- ein breitbandiges Ultraschallmikrophon;
- Messelektronik, aufweisend eine Bibliothek von Cepstra für bekannte elektrische Teilentladungen;
- Nutzeroberfläche;
- optional einen Entfernungsmesser;

wobei das Ultraschallmessgerät dazu eingerichtet ist, die akustischen Auswirkungen einer elektrischen Teilentladung, die sich durch Luftultraschall ausbreitet zu detektieren und zu bewerten;
und wobei das Ultraschallmessgerät dazu eingerichtet ist einen auszuwertenden Frequenzbereich in Abhängigkeit einer Entfernung des Ultraschallmikrophons zu einer vermessenen Ultraschallquelle auszuwählen.

Weiterhin wird die Verwendung des erfindungsgemäßen Verfahrens oder des erfindungsgemäßen Ultraschallmessgerätes für die Detektion und Bewertung von elektrischen Störstellen, insbesondere von elektrischen Teilentladungen beschrieben.

### Detaillierte Beschreibung

Merkmale, die im Folgenden für das erfindungsgemäße Verfahren beschrieben werden, gelten genauso für das erfindungsgemäße Ultraschallmessgerät und umgekehrt.

Ultraschallquellen gemäß der vorliegenden Erfindung sind, wie bereits eingangs beschrieben, Quellen von denen verursacht durch elektrische Teilentladungen Luftultraschall ausgesendet wird. Besonders bevorzugt sind die Ultraschallquellen Störstellen, bevorzugt elektrische Störstellen, an denen elektrische Teilentladungen auftreten.

Gemäß dem erfindungsgemäßen Verfahren wird ein breitbandiges Ultraschallsignal mindestens einer Ultraschallquelle gemessen. In einer bevorzugten Ausführungsform der vorliegenden Erfindung wird ein Ultraschallsignal genau einer Ultraschallquelle gemessen. Breitbandig bedeutet in diesem Zusammenhang, dass bevorzugt Frequenzen im Bereich von 10 kHz bis 100 kHz, insbesondere im Bereich von 20 kHz bis 100 kHz, erfasst werden. Das Ultraschallsignal wird bevorzugt mit einer Abtastrate fₛ > 200 kHz abgetastet.

Erfindungsgemäß wird mindestens ein Frequenzbereich des Ultraschallsignals ausgewertet, um das Ultraschallsignal zu bewerten.

In einer Ausführungsform der vorliegenden Erfindung wird die Entfernung zwischen Ultraschallquelle und Ultraschallmikrophon gemessen. Anhand der gemessenen Entfernung wird ein Frequenzbereich des Ultraschallsignals für die Auswertung ausgewählt. Mit zunehmender Entfernung von der Ultraschallquelle wird Ultraschall höherer Frequenzen stärker gedämpft als das Ultraschallsignal niedrigerer Frequenzen. Mit zunehmender Entfernung verschiebt sich der Frequenzbereich, der ausgewertet wird, daher zu kleineren Frequenzen. Der Frequenzbereich für die Auswertung hängt dabei von der Schallleistung der Quelle und von der Empfindlichkeit der Messkette und von deren Dynamikbereich ab. Für Entfernungen zwischen Ultraschallmikrophon und Schallquelle von mehreren zehn Metern hat sich gezeigt, dass der Frequenzbereich für die Auswertung um 40 kHz zentriert liegt. Für Entfernungen bis 10 m zeigt sich, dass ein Frequenzbereich um 100 kHz am günstigsten ist. Für Bereiche um 100 m und darüber wird ein Frequenzbereich um die 10 kHz ausgewertet. Damit ist vorteilhafterweise mit der vorliegenden Erfindung ein großer Entfernungsbereich zwischen Ultraschallmikrophon und Ultraschallquelle erfassbar. Teilentladungen als akustische Quellen, die als Störquellen wirken, können somit in einer Entfernung zum Ultraschallmikrophon unterhalb von 10 m bis zu einer Entfernung von 200 m und darüber detektiert und bewertet werden.

In einer bevorzugten Ausführungsform der vorliegenden Erfindung, wird bei einer Entfernung zwischen Ultraschallmikrophon und Ultraschallquelle bis 10 m ein Frequenzbereich des Ultraschallsignals ausgewertet, der zwischen 60 kHz und 100 kHz, bevorzugt zwischen 70 kHz und 100 kHz, besonders bevorzugt zwischen 80 kHz und 100 kHz liegt.

In einer bevorzugten Ausführungsform der vorliegenden Erfindung wird bei einer Entfernung zwischen Ultraschallmikrophon und Ultraschallquelle zwischen 10 m und 100 m ein Frequenzbereich des Ultraschallsignals ausgewertet, der zwischen 20 kHz und 60 kHz, bevorzugt zwischen 30 kHz und 60 kHz, besonders bevorzugt zwischen 40 kHz und 60 kHz liegt.

In einer bevorzugten Ausführungsform der vorliegenden Erfindung wird bei einer Entfernung zwischen Ultraschallmikrophon und Ultraschallquelle über 100 m ein Frequenzbereich des Ultraschallsignals ausgewertet, der zwischen 10 kHz und 40 kHz, bevorzugt zwischen 10 kHz und 30 kHz, besonders bevorzugt zwischen 10 kHz und 20 kHz liegt.

In einer Ausführungsform der Erfindung werden Ultraschallquellen bis zu einer Entfernung von 200 m zwischen Ultraschallquelle und Ultraschallmikrophon detektiert und bewertet.

In einer Ausführungsform der Erfindung hat der mindestens eine Frequenzbereich, der für die Auswertung genutzt wird, typischerweise eine Bandbreite von 10 bis 20 kHz.

Die elektrischen Störstellen, insbesondere elektrische Teilentladungen, werden ab einer Entfernung gemessen, bei der die Elemente der Messkette aus Messelektronik und Ultraschallmikrophon sensitiv genug sind und sich dadurch das durch die Entladung verursachte Signal aus dem Störgeräusch (Umgebungsgeräusche, elektronisches Rauschen) heraushebt. In einer Ausführungsform liegt der Schwellenwert für das elektronische Rauschen bei etwa 20 dB (auf p₀ = 20 µPa bezogen). Signale aus determinierten Quellen lassen sich bei einer Pegeldifferenz von ca. 5 dB zum Rauschen sicher erfassen.

Die frequenzabhängige Dämpfung des Ultraschallsignals hängt von vielen Faktoren ab. Neben der reinen Dämpfung, die physikalisch gut zu beschreiben wäre, spielt auch die Messumgebung wie Untergrund, Reflexionsumgebungen, Vegetation aber auch Feuchtigkeit eine Rolle. Die Entfernungsberücksichtigung erfolgt deshalb bevorzugt aus dem breitbandigen Spektrum selbst. Die Auswahl des Frequenzbereichs, in dem das Ultraschallsignal ausgewertet wird, erfolgt dann in Abhängigkeit der verfügbaren Signalstärke, die wiederum von der Entfernung zwischen Ultraschallmikrophon und Ultraschallquelle abhängt. Dabei wird der Frequenzbereich mit der höchsten Signalstärke ausgewertet. Die Entfernung zwischen Ultraschallquelle und Ultraschallmikrophon muss dem Prüfer daher nicht zwingend zur Verfügung stehen.

Vorteilhafterweise steht einem Nutzer das gesamte breitbandig gemessene Ultraschallsignal zur Verfügung, so dass es möglich ist, auch mehr als einen Frequenzbereich auszuwerten, bzw. verschiedene Frequenzfilter auf das gemessene Signal anzuwenden.

Bevorzugt wird das detektierte Zeitsignal in Echtzeit verarbeitet. In einer Ausführungsform der vorliegenden Erfindung wird das gesamte Zeitsignal aufgezeichnet und gespeichert. In diesem Fall stehen die Daten vorteilhafterweise auch für eine Datenverarbeitung zu einem späteren Zeitpunkt noch zur Verfügung.

Im Rahmen der vorliegenden Erfindung wird die Varianz und damit die Fluktuation der Zeit-Frequenz-Eigenschaften des Signals als Muster bezeichnet. Das Muster wird maßgeblich durch die zeitliche Variation der Signalamplitude bestimmt. Die Zeit-Signalform ist eine Mischung aus stochastischen und systematischen Abfolgen akustischer Signale. Darin ist die eigentliche Information über Störstellen, insbesondere über elektrische Teilentladungen, enthalten. Die Elementarereignisse sind dabei über einen breiten Frequenzbereich verteilt. Als Elementarereignisse werden im Rahmen der vorliegenden Erfindung Teilentladungen bezeichnet, die eine akustische Auswirkung haben, die sich durch Luftultraschall ausbreitet.

Das Zeitsignal kann durch bekannte Mittel, wie beispielsweise einer Fourier-Transformation in den Frequenzraum überführt werden. Die Fouriertransformation kann sowohl an den hochfrequenten Ultraschalldaten als auch an den hörbar gemachten Daten mit reduzierter Datenrate ausgeführt werden. Eine günstige Darstellung im Zeit-Frequenz-Raum wird als Spektrogramm bezeichnet.

Das hochfrequente, gemessene Ultraschall-Zeitsignal ist die Grundlage für alle weiteren Berechnungen gemäß der vorliegenden Erfindung. Dieses hochfrequente, gemessene Ultraschallsignal an sich, ist für die direkte Nutzung in der Prüfung nicht geeignet, jedoch hat sich gezeigt, dass bei einer geeigneten Verarbeitung des Hochfrequenz-Ultraschallsignals dieses für die Nutzung in der Prüfung zugänglich gemacht werden kann.

In einer Ausführungsform der vorliegenden Erfindung wird aus dem für die Auswertung ausgewählten Frequenzbereich des Messsignals ein geeignet gefiltertes neues Zeitsignal generiert.

Das neue Zeitsignal kann durch eines der im Folgenden genannten Verfahren erzeugt werden. Allen Verfahren gemein ist, dass die für das Ultraschallsignal charakteristische Modulation erhalten bleibt. Sämtliche Verfahren werden bevorzugt in Echtzeit angewendet.
*a. Breitbandige Berechnung und Darstellung der Spektren*
b. *Heterodynsignal:* Eine Ausführungsform hat eine Bandbreite von +/-2 kHz um die Trägerfrequenz. Typische Anwendungen verwenden eine Trägerfrequenz von 40 kHz aufgrund der verfügbaren einfachen Sensoren. Aufgrund der breitbandigen digitalen Messung kann die Trägerfrequenz und die Bandbreite beliebig variiert werden. Eine gleichzeitige Berechnung vieler Frequenzbänder in Heterodyn-Technik ist möglich. Dies kann auch für die Audioausgabe im Hörbereich genutzt werden. Das Signal hat eine geringere Zeitauflösung als das originale Hochfrequenzsignal. Die Heterodyn-Technik an sich ist dem Fachmann zwar bekannt, jedoch ist die Verwendung gemäß dem vorliegenden Verfahren als Filterbank dem Fachmann so nicht geläufig und in analoger Form auch nicht realisierbar. Dies wird erst ermöglicht, indem gemäß dem vorliegenden Verfahren, die Heterodyn-Technik in Verbindung mit einem breitbandig detektierten Ultraschallsignal genutzt wird.
c. *Vocodersignal:* Mit dieser Datenkompression wird das Ultraschallsignal hörbar gemacht. Die zeitliche Dynamik bleibt auch im Höreindruck erhalten. Da dieser Signaltyp eine Frequenzkomprimierung des gesamten Ultraschallbereichs abbildet, können auch für das Vocodersignal Bandpässe berechnet werden, die jeweils einem Ultraschall-Frequenzband zugeordnet werden können. Wenn das Ultraschall-Signal in 1, 2, 4, 6 oder 12 Bänder zerlegt wird, betrifft dies in der skalierten Form auch das Vocodersignal mit der analogen Anzahl von Bändern. Die Anwendung des Vocoderverfahrens ist dem Fachmann bekannt.
d. *Bandpass gefilterte Hochfrequenz-Signale:* Eine Filterbank trennt das Signal im Zeitbereich in unterschiedliche Zeitsignale auf. Aufgrund der breitbandigen akustischen Signale ist die Information über die Fluktuation in allen Frequenzbändern gleich (bei möglicherweise unterschiedlicher Amplitude). Zur Bewertung für qualitative Zwecke ist ein Frequenzband, in dem eine genügend große Amplitude vorhanden ist, ausreichend. Für jedes Frequenzband kann ein repräsentativer Amplitudenwert verwendet werden. Geeignet ist eine gemittelte Amplitude. Ein Nachteil dieser Verfahrensvariante ist, dass hierbei die Möglichkeit spektraler Berechnungen verloren geht.

In einer weiteren Ausführungsform der Erfindung werden von dem mit dem Ultraschallmikrophon detektierten Zeitsignal die Einhüllenden der zeitlichen Fluktuationen berechnet. Dies kann durch eine Hilbert-Transformation des Zeitsignals erreicht werden. Diese Vorgehensweise ist insbesondere dann vorteilhaft, wenn auf die spektrale Information verzichtet werden kann. Da die Einhüllenden ebenfalls Zeitfunktionen sind, können diese die (globalen) Amplitudenfluktuationen des detektierten Ultraschallsignals widerspiegeln und für die bereits beschriebenen Berechnungsverfahren a. bis d. verwendet werden. In einer Ausführungsform der vorliegenden Erfindung werden die Einhüllenden der zeitlichen Fluktuationen des detektierten Ultraschallsignals berechnet und anschließend als ein neues Zeitsignal verwendet.

Zur Objektivierung der Bewertung wird ein weiterer Signalverarbeitungsschritt, bevorzugt in Echtzeit, eingefügt. In Zeitsignalen mit stochastischem Charakter lassen sich versteckte und sich wiederholende Strukturen überraschend gut mit der Operation Cepstrum aus dem Bereich der Fourieranalyse sichtbar machen. Die Signale werden dabei auf eine inverse Frequenz bezogen. Diese ist dann formal wieder eine Zeit und kann als ein Maß für den Wiederholabstand verstanden werden. In einer Ausführungsform der vorliegenden Erfindung wird für das Ultraschallsignal ein Cepstrum berechnet.

Das Cepstrum kann als geeignete Grundlage für eine visuelle Unterscheidung (Betrachtung durch Prüfer) oder als Eingang für einen weiteren Signalverarbeitungsschritt zur automatischen Bewertung dienen. Bei der visuellen Bewertung durch einen Prüfer kann die Bewertung einmal auf der Grundlage der Erfahrung des Prüfers geschehen. Möglich ist aber auch, dass das berechnete Cepstrum entweder durch einen Prüfer oder aber automatisch mit Methoden der Mustererkennung mit bereits bekannten Cepstra-Mustern, verglichen wird, wobei die bekannten Cepstra die Ultraschallsignale von genau definierten Arten von elektrischen Teilentladungen widerspiegeln. Basis hierfür ist eine umfangreiche experimentelle Datenbasis.

Die unterschiedlichen Arten von Entladungsvorgängen haben unterschiedliche Ausprägungen hinsichtlich ihrer Wiederholungsstruktur. Es gibt sehr gleichmäßige Wiederholungen bis hin zu einer fast stochastischen Wiederholungsstruktur. Diese Struktur ist charakteristisch für unterschiedliche Varianten elektrischer Teilentladungen. Mit dem vorliegenden Verfahren kann daher aus der Signalstruktur, der Typ der Störstelle objektiv beschrieben werden, ohne dass, wie mit den Verfahren aus dem Stand der Technik üblich, auf die subjektive Bewertung von erfahrenen Prüfern mittels des Höreindruckes (Heterodynverfahren) und der Visualisierung des (hörbaren) Audiosignals zurückgegriffen werden muss. Das vorliegende Verfahren stellt damit vorteilhafterweise ein Prüfverfahren für Störstellen, insbesondere für elektrische Teilentladungen an Störstellen zur Verfügung, welches eine objektive Prüfung unabhängig vom jeweiligen Prüfer ermöglicht.

In einer weiteren Ausführungsform der vorliegenden Erfindung kann die Berechnung des Cepstrum auch im Nachhinein mit Hilfe der gespeicherten Messdaten erfolgen.

Es hat sich gezeigt, dass man bei größeren Entfernungen die Mess- oder Bewertungsfrequenz hin zu deutlich kleineren Frequenzen verschieben kann. Die Bewertung kann korrekt erfolgen, da das zeitliche Bewertungsmuster, das mit dem Cepstrum erfasst werden kann, erhalten bleibt.

Im Prinzip kann man bei sehr großen Entfernungen auch die hörbaren Frequenzen verwenden, wobei allerdings störender hörbarer Schall aus der Bewertung eliminiert werden muss. Damit können Entfernungen bis zu einigen hundert Metern erreicht werden. Dies ist mit den bisher bekannten Verfahren nicht möglich. Die bei größeren Entfernungen zwischen Ultraschallquelle und Ultraschallmikrophon schlechter werdende Richtwirkung des Schalls lässt sich durch den Einsatz eines Hohlspiegels teilweise kompensieren. In einer Ausführungsform des erfindungsgemäßen Verfahrens wird die Richtwirkung des Ultraschalls daher mit einem Hohlspiegel teilweise korrigiert.

Die Auswahl eines geeigneten Frequenzbandes erleichtert die Prüfung für den Nutzer. Die Auswahl (Heterodyn, Bandfilter, oder Breitband) kann digital erfolgen. Bei der Verwendung des Breitbandsignals und Speicherung des Hochfrequenz-Signals können alle Situationen (Offline) nachberechnet werden.

Die Erfindung stellt weiterhin ein Ultraschallmessgerät zur Detektion von breitbandigem Ultraschall zur Verfügung. Das Ultraschallmessgerät ist bevorzugt ein Ultraschallprüfgerät, welches entsprechend zu Prüfzwecken zum Einsatz kommen kann.

Gemäß der vorliegenden Erfindung wird digitale Messtechnik eingesetzt. Die Ultraschallmesstechnik muss hierfür mit einem breitbandigen Ultraschallmikrophon ausgestattet sein. Bevorzugt ist dies ein Ultraschallmikrophon, das Frequenzen von 10 bis 100 kHz erfassen kann. In einer weiteren Ausführungsform der Erfindung ist dies ein Mikrophon, welches auch für hohe Frequenzen (bis ca. 100 kHz) ausgelegt ist und mit geeigneten Frequenzfiltern in der digitalen Messkette betrieben wird. Geeignete Frequenzfilter sind beispielsweise 1/3-Oktavfilter oder weitere Unterteilungen (1/6- oder 1/12-Oktav-Filter) sowie frei wählbare digitale Filter.

Das Ultraschallmikrophon ist mit einer geeigneten Messelektronik in einer Messkette verbunden. Das Prüfgerät integriert eine digital gespeicherte Bibliothek von Cepstra, die die Ultraschallsignale von genau definierten Arten von elektrischen Teilentladungen widerspiegeln.

Weiterhin weist das Ultraschallmessgerät eine Nutzeroberfläche auf, mit deren Hilfe ein Nutzer navigieren kann und bestimmte Verfahrensschritte auswählen kann. Derart ist es möglich eine Messung auszulösen oder die Auswertung der Messdaten zu beeinflussen. Das Messergebnis kann vorteilhafterweise ebenfalls auf der Nutzeroberfläche dargestellt werden. In einer bevorzugten Ausführungsform ist die Nutzeroberfläche eine grafische Nutzeroberfläche mit Touchbedienung.

Optional weist das Ultraschallmessgerät einen Entfernungsmesser auf. In einer bevorzugten Ausführungsform weist das Ultraschallmessgerät einen Entfernungsmesser auf. Die gemessene Entfernung kann dann für die Auswahl des Frequenzbereiches genutzt werden, der ausgewertet werden soll. Wie bereits beschrieben ist eine Entfernungsmessung jedoch nicht zwingend notwendig, da die Information über den Einfluss der Entfernung bereits in den breitbandigen Ultraschalldaten enthalten ist. Die Integration der Möglichkeit einer direkten Entfernungsmessung kann jedoch zur Bestätigung der Bewertung eingesetzt werden oder um die Vergleichbarkeit unterschiedlicher Messpositionen zu gewährleisten.

In einer Ausführungsform der Erfindung weist das Ultraschallmessgerät weiterhin einen Hohlspiegel auf. Dies erweist sich insbesondere dann als vorteilhaft, wenn sich das Ultraschallmessgerät in größerer Entfernung von der Quelle des Ultraschallsignals befindet oder wenn sehr kleine Schallpegel vorliegen. Durch Einsatz des Hohlspiegels lässt sich die schlechter werdende Richtwirkung des Ultraschalls kompensieren und das Signal-zu-Rausch Verhältnis wird verbessert. Die Signalverbesserung liegt bei 6 dB. Damit können Schallquellen gleicher Leistung etwa doppelt so weit gefunden und bewertet werden. Dabei wirkt sich die Kombination der Verwendung von Hohlspiegeln und eines Frequenzbandes mit niedrigeren Ultraschallfrequenzen günstig auf die Prüfbarkeit von Teilentladungen bei größeren Entfernungen aus.

Das Ultraschallmessgerät, insbesondere Ultraschallprüfgerät ist besonders bevorzugt als Handgerät ausgebildet. Somit sind eine einfache Handhabung, sowie ein unkomplizierter Transport des Gerätes möglich. Das Ultraschallmessgerät kann damit flexibel als mobiles Prüfsystem eingesetzt und angewendet werden.

Das erfindungsgemäße Verfahren und das erfindungsgemäße Ultraschallmessgerät werden bevorzugt für die Detektion und Bewertung von Störstellen, insbesondere von elektrischen Teilentladungen, verwendet. Die Störstellen sind bevorzugt elektrische Störstellen an denen Teilentladungen auftreten, die Ultraschallsignale verursachen, die sich durch Luftultraschall fortpflanzen. Das Verfahren und das Ultraschallmessgerät sind erfindungsgemäß dafür ausgelegt, solche Störstellen bis zu einer Entfernung zwischen Ultraschallmikrophon und Ultraschallquelle von etwa 200 m zu detektieren und zu bewerten.

Im Folgenden wird die Erfindung anhand von 6 Figuren und 1 Ausführungsbeispiel näher erläutert.
- Figur 1: stellt ein Fourierspektrum eines Einzelereignisses einer Entladung dar;
- Figur 2: stellt eine Zeit-Frequenz-Darstellung einer Entladungssequenz dar;
- Figur 3: stellt ein Cepstrum dar;
- Figur 4: stellt die Anpassung des Frequenzabschnitts, der ausgewertet wird an die entfernungsabhängige Dämpfung des Ultraschallsignals dar;
- Figur 5: (A) und (B) stellen schematisch ein Ultraschallsignal dar und die Dämpfung des Signals mit der Entfernung von der Ultraschallquelle;
- Figur 6: stellt die Dämpfung von Ultraschallsignalen in verschiedenen Frequenzbereichen mit der Entfernung von der Ultraschallquelle dar.

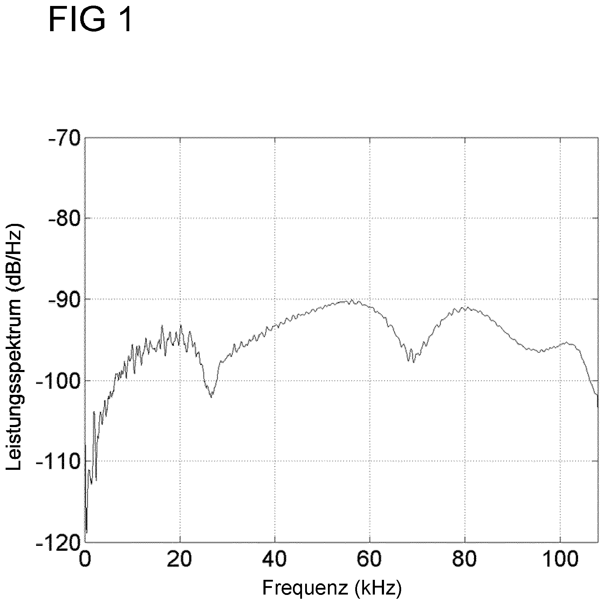

**Figur 1** stellt ein Fourierspektrum eines Einzelereignisses einer Entladung über einen breiten Frequenzbereich dar. Das Spektrum zeigt, dass bei Frequenzen um 50 bis 60 kHz ein deutlicher Signalgewinn (20 dB) gegenüber der Frequenz(-lücke) bei 25 bis 40 kHz gefunden werden kann. Dies kann zur Einstellung einer optimalen Messfrequenzen bzw. des optimalen Frequenzbandes genutzt werden. Die Optimierung muss dabei an verschiedene Prüfsituationen angepasst werden. Verschiedene Entladungsarten und Elektrodenformen erzeugen unterschiedliche spektrale Verteilungen im Fourierspektrum.

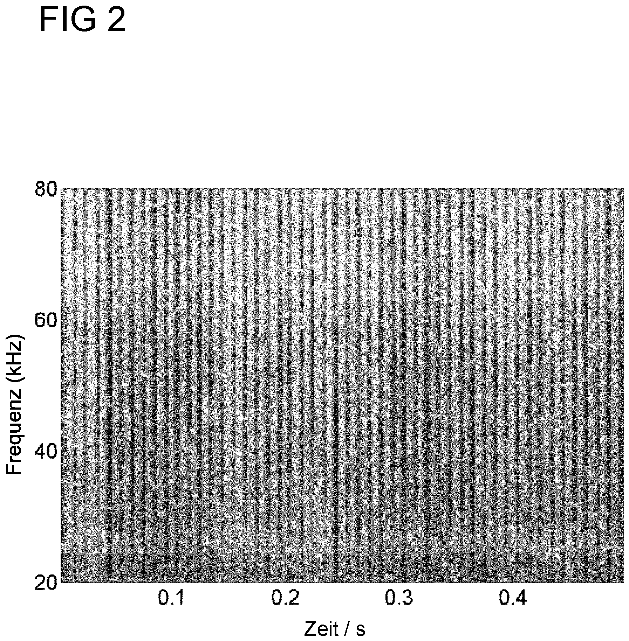

**Figur 2** zeigt die Zeit-Frequenz-Darstellung einer typischen Entladungssequenz. In diesem Beispiel könnten verschiedene Frequenzbänder ausgewählt werden, um die zeitliche Fluktuation darzustellen.

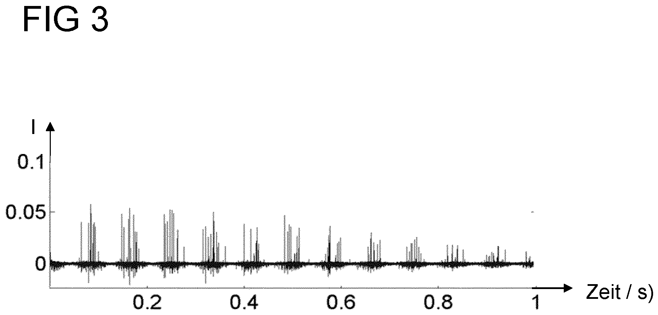

Das Cepstrum in **Figur 3** zeigt das zeitliche Wiederholmuster von Entladungsvorgängen. Die unterschiedlichen Arten von Entladungsvorgängen haben unterschiedliche Ausprägungen hinsichtlich ihrer Wiederholungsstruktur. Es gibt sehr gleichmäßige Wiederholungen bis hin zu einer fast stochastischen Wiederholungsstruktur. Diese Struktur ist charakteristisch. Gemäß dem vorliegenden Verfahren wird objektiv mit Hilfe der Signalstruktur, der Typ der Störstelle, insbesondere der elektrischen Teilentladung, beschrieben. Dieser Bewertung wird gegenwärtig, mit den Verfahren aus dem Stand der Technik, subjektiv von erfahrenen Prüfern mittels des Höreindruckes (Heterodynverfahren) und dessen Visualisierung realisiert.

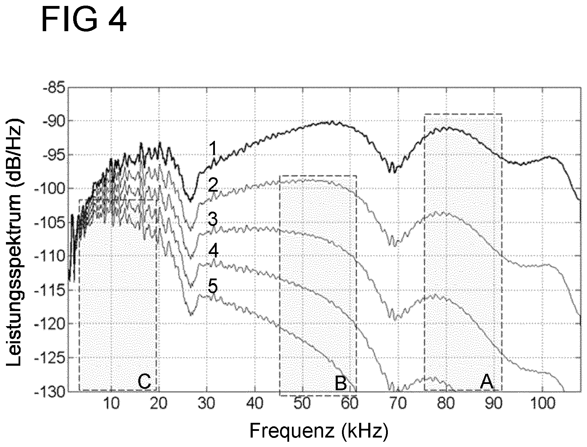

**Figur 4** zeigt die Auswahl des optimalen Frequenzbereichs für die Auswertung des Messsignals in Abhängigkeit von der Entfernung des Ultraschallmikrophons von der Ultraschallquelle. Die Ultraschallsignale 1 bis 5 wurden mit zunehmender Entfernung gemessen. Die Entfernungen zwischen Ultraschallmikrophon und Schallquelle waren dabei wie folgt:

| Kurve | Entfernung zwischen Ultraschallmikrophon und Schallquelle |
|---|---|
| 1 | 5 m |
| 2 | 10 m |
| 3 | 40 m |
| 4 | 100 m |
| 5 | 200 m |

Dabei war die Entfernung des Ultraschallmessegerätes zur Ultraschallquelle für die Messkurve 1 am geringsten und für die Messkurve 5 am größten. Deutlich ist die frequenzabhängige Dämpfung des Ultraschallsignals mit zunehmender Entfernung zu erkennen. Größere Frequenzen werden deutlich stärker gedämpft als kleinere Frequenzen. Für die Messung der Kurve 1 mit dem geringsten Abstand zwischen Ultraschallmessgerät und Ultraschallquelle wird für die Auswertung der Frequenzbereich A gewählt, da hier auch mit dem geringsten Störschall zu rechnen ist. Für die Kurven 2 und 3 wird hingegen der Frequenzbereich B für die Auswertung gewählt, da hier die Dämpfung des Ultraschallsignals wesentlich geringer ist als im Bereich A. Für die Kurven 4 und 5 ist eine Auswertung im Bereich A gar nicht mehr möglich, da für diese Frequenzen so gut wie kein Signal mehr gemessen werden kann. Ultraschallsignale in diesem Frequenzbereich werden in der Luft aufgrund der großen Entfernung zwischen Ultraschallquelle und Ultraschallmessgerät nahezu komplett gedämpft. Eine Auswertung ist für die Messung dieser Entfernung jedoch noch für den Frequenzbereich C möglich. Erfindungsgemäß wird damit eine Detektion und Bewertung von Ultraschalsignalen von elektrischen Teilentladungen auch auf große Distanzen ermöglicht.

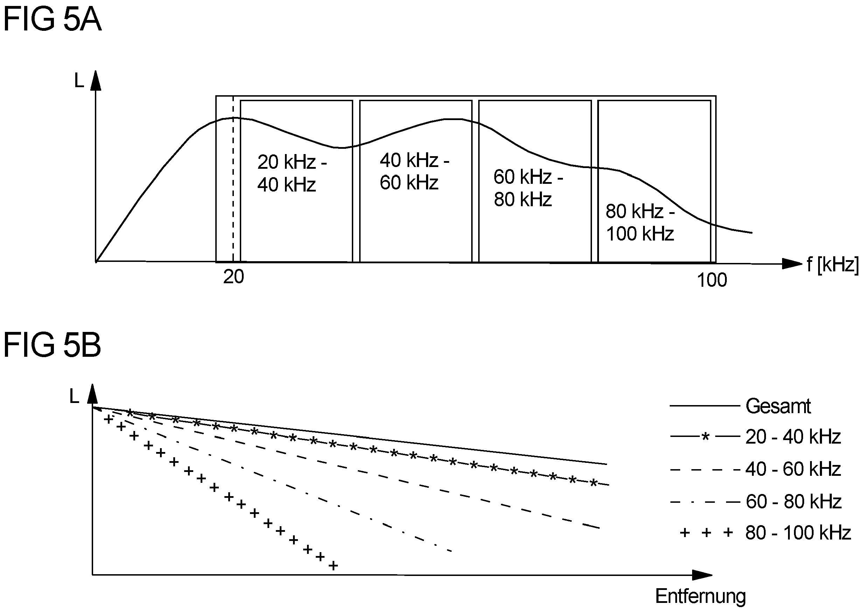

**Figur 5 (A)** stellt schematisch ein Ultraschallsignal dar. Das gesamte Ultraschallsignal wird breitbandig, das heißt im Frequenzbereich von 10 kHz bis 100 kHz mit der erfindungsgemäßen Vorrichtung gemessen. Bei der Weiterverarbeitung des Ultraschallsignals kann mit Hilfe von Filtern eine Auswahl getroffen werden, welcher Frequenzbereich des gesamten Signals für die weitere Auswertung verwendet werden soll. Abgebildet sind Filter von 20 kHz bis 40 kHz, von 40 kHz bis 60 kHz, von 60 kHz bis 80 kHz und von 80 kHz bis 100 kHz. Diese Filter dienen lediglich der Veranschaulichung, selbstverständlich kann auch eine andere Filterbreite oder ein anderer Frequenzbereich gewählt werden. Beispielsweise ist es auch möglich das Ultraschallsignal im Frequenzbereich von 50 kHz bis 80 kHz zu Filtern. **Figur 5 (B)** stellt schematisch die Dämpfung verschiedener Frequenzanteile des Ultraschallsignals mit zunehmender Entfernung zwischen Ultraschallquelle und Ultraschallmikrophon dar. Deutlich zu erkennen ist, dass für Signalanteile mit höheren Frequenzen das Signal mit zunehmender Entfernung stärker gedämpft wird. Mit zunehmender Entfernung ist es daher sinnvoll Signalanteile des gemessenen breitbandigen Ultraschallsignals auszuwerten, die niedrigere Frequenzbereiche beinhalten.

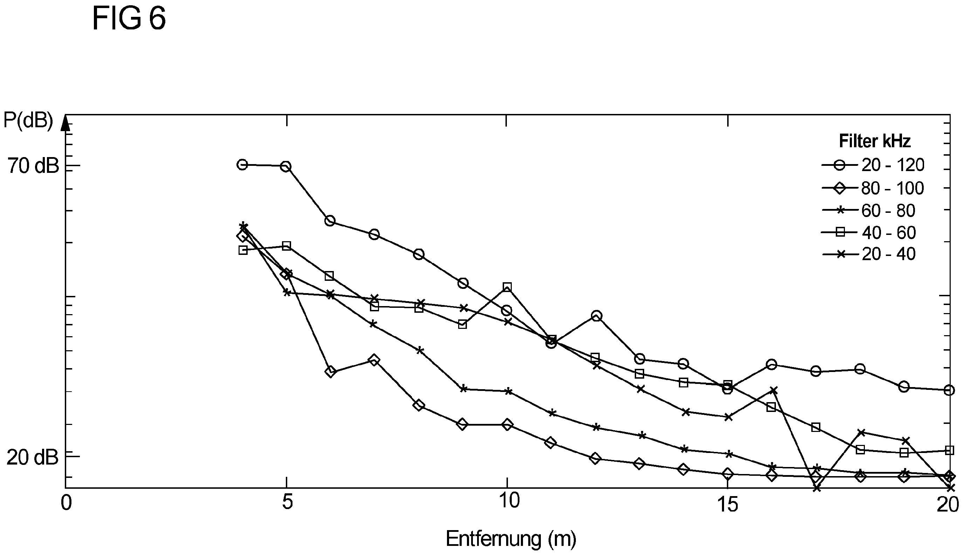

**Figur 6** stellt die Daten der Messung von breitbandigen Ultraschallsignalen für verschiedene Entfernungen von Ultraschallquelle zu Ultraschallmikrophon dar.

### Ausführungsbeispiel 1

Beispielhaft wurden Messungen eines Ultraschallsignals einer elektrischen Teilentladung für Entfernungen zwischen 4 m und 20 m durchgeführt. Wie bereits beschrieben ist das Verfahren bis auf Entfernungen von bis zu 200 m anwendbar. Für jede Entfernung wurde mit einer erfindungsgemäßen Vorrichtung ein breitbandiges Ultraschallsignal im Frequenzbereich von 10 kHz bis 120 kHz aufgenommen. Das breitbandige Ultraschallsignal wurde anschließend mit einem Filter von 20 kHz bis 120 kHz weiterverarbeitet und der Schalldruck für diese Entfernung bestimmt. Auf das gemessene breitbandige Ultraschallsignal wurde ebenfalls mit Frequenzfiltern im Bereich von 80 kHz bis 100 kHz, im Bereich von 60 kHz bis 80 kHz, im Bereich von 40 kHz bis 60 kHz und im Bereich von 20 kHz bis 40 kHz ausgewertet und jeweils der Schalldruckpegel berechnet. Die Schalldruckpegel für die Auswertung in den einzelnen Frequenzbereichen in Abhängigkeit von der Entfernung sind in der Figur 6 dargestellt. Deutlich ist zu erkennen, dass mit zunehmender Entfernung Signale im höheren Frequenzbereich einen niedrigeren Schalldruckpegel aufweisen als Signale im niedrigeren Frequenzbereich. Dies wird durch die stärkere Dämpfung mit zunehmender Frequenz verursacht.

## Patentansprüche

1. Verfahren zur Detektion und Bewertung von Ultraschallquellen mit einem breitbandigen Ultraschallmikrophon, wobei die Ultraschallquellen akustische Auswirkungen einer elektrischen Teilentladung darstellen, die sich durch Luftschall ausbreiten, **dadurch gekennzeichnet, dass**
ein breitbandiges Ultraschallsignal mindestens einer Ultraschallquelle gemessen wird; mindestens ein Frequenzbereich des Ultraschallsignals ausgewertet wird;
und dass die Auswahl des Frequenzbereichs, in dem das Ultraschallsignal ausgewertet wird, in Abhängigkeit von der Entfernung zwischen Ultraschallmikrophon und Ultraschallquelle erfolgt.

2. Verfahren nach Anspruch 1, **dadurch gekennzeichnet, dass** ein breitbandiges Ultraschallsignal mit Frequenzen von 10 kHz bis 100 kHz gemessen wird.

3. Verfahren nach einem der vorangegangenen Ansprüche, **dadurch gekennzeichnet, dass** für Entfernungen zwischen Ultraschallmikrophon und Ultraschallquelle bis 10 m ein Frequenzbereich des Ultraschallsignals ausgewertet wird, der zwischen 60 kHz und 100 kHz, bevorzugt zwischen 70 kHz und 100 kHz, besonders bevorzugt zwischen 80 kHz und 100 kHz liegt.

4. Verfahren nach einem der vorangegangenen Ansprüche, **dadurch gekennzeichnet, dass** für Entfernungen zwischen Ultraschallmikrophon und Ultraschallquelle zwischen 10 m und 100 m ein Frequenzbereich des Ultraschallsignals ausgewertet wird, der zwischen 20 kHz und 60 kHz, bevorzugt zwischen 30 kHz und 60 kHz, besonders bevorzugt zwischen 40 kHz und 60 kHz liegt.

5. Verfahren nach einem der vorangegangenen Ansprüche, **dadurch gekennzeichnet, dass** für Entfernungen zwischen Ultraschallmikrophon und Ultraschallquelle über 100 m ein Frequenzbereich des Ultraschallsignals ausgewertet wird, der zwischen 10 kHz und 40 kHz, bevorzugt zwischen 10 kHz und 30 kHz, besonders bevorzugt zwischen 10 kHz und 20 kHz liegt.

6. Verfahren nach einem der vorangegangenen Ansprüche, **dadurch gekennzeichnet, dass** die Entfernungsberücksichtigung aus dem breitbandigen Spektrum selbst erfolgt.

7. Verfahren nach einem der vorangegangenen Ansprüche, **dadurch gekennzeichnet, dass** die Entfernung zwischen Ultraschallquelle und Ultraschallmikrophon, gemessen wird.

8. Verfahren nach einem der vorangegangenen Ansprüche, **dadurch gekennzeichnet, dass** für das Ultraschallsignal ein Cepstrum berechnet wird.

9. Verfahren nach einem der vorangegangenen Ansprüche, **dadurch gekennzeichnet, dass** das Ultraschallsignal bewertet wird, indem das berechnete Cepstrum mit Cepstra verglichen wird, die für Ultraschallsignale von genau definierten Arten von elektrischen Teilentladungen vorliegen.

10. Verfahren nach einem der vorangegangenen Ansprüche, **dadurch gekennzeichnet, dass** die Bewertung des Ultraschallsignals in Echtzeit stattfindet.

11. Verfahren nach einem der vorangegangenen Ansprüche, **dadurch gekennzeichnet, dass** Ultraschallquellen bis zu einer Entfernung von 200 m detektiert und bewertet werden.

12. Ultraschallmessgerät zur Detektion von breitbandigem Ultraschall, dazu eingerichtet ein Verfahren gemäß einem der Ansprüche 1 bis 11 durchzuführen, aufweisend
• ein breitbandiges Ultraschallmikrophon;
• Messelektronik, aufweisend eine Bibliothek von Cepstra für bekannte elektrische Teilentladungen;
• Nutzeroberfläche;
• optional einen Entfernungsmesser;
wobei das Ultraschallmessgerät dazu eingerichtet ist, die akustischen Auswirkungen einer elektrischen Teilentladung, die sich durch Luftultraschall ausbreitet, zu detektieren und zu bewerten;
**dadurch gekennzeichnet, dass**
das Ultraschallmessgerät dazu eingerichtet ist, einen auszuwertenden Frequenzbereich in Abhängigkeit einer Entfernung des Ultraschallmikrophons zu einer vermessenen Ultraschallquelle auszuwählen.

13. Ultraschallmessgerät nach Anspruch 12, **dadurch gekennzeichnet, dass** das Ultraschallmessgerät weiterhin einen Hohlspiegel aufweist.

14. Ultraschallmessgerät nach einem der Ansprüche 12 oder 13, **dadurch gekennzeichnet, dass** das Ultraschallmessgerät als Handgerät ausgebildet ist.

15. Verwendung des Verfahrens gemäß einem der Ansprüche 1 bis 11 oder des Ultraschallmessgerätes gemäß einem der Ansprüche 12 bis 14 für die Detektion und Bewertung von elektrischen Störstellen.

## Claims

1. Method for detecting and assessing ultrasonic sources with a broadband ultrasonic microphone, wherein the ultrasonic sources constitute acoustic effects of an electrical partial discharge which propagate through airborne sound, **characterized in that**
a broadband ultrasonic signal from at least one ultrasonic source is measured;
at least one frequency range of the ultrasonic signal is evaluated;
and **in that** the frequency range in which the ultrasonic signal is evaluated is selected on the basis of the distance between the ultrasonic microphone and the ultrasonic source.

2. Method according to Claim 1, **characterized in that** a broadband ultrasonic signal with frequencies of 10 kHz to 100 kHz is measured.

3. Method according to one of the preceding claims, **characterized in that**, for distances between the ultrasonic microphone and the ultrasonic source of up to 10 m, a frequency range of the ultrasonic signal which is between 60 kHz and 100 kHz, preferably between 70 kHz and 100 kHz, particularly preferably between 80 kHz and 100 kHz, is evaluated.

4. Method according to one of the preceding claims, **characterized in that**, for distances between the ultrasonic microphone and the ultrasonic source of between 10 m and 100 m, a frequency range of the ultrasonic signal which is between 20 kHz and 60 kHz, preferably between 30 kHz and 60 kHz, particularly preferably between 40 kHz and 60 kHz, is evaluated.

5. Method according to one of the preceding claims, **characterized in that**, for distances between the ultrasonic microphone and the ultrasonic source of more than 100 m, a frequency range of the ultrasonic signal which is between 10 kHz and 40 kHz, preferably between 10 kHz and 30 kHz, particularly preferably between 10 kHz and 20 kHz, is evaluated.

6. Method according to one of the preceding claims, **characterized in that** the distance is considered from the broadband spectrum itself.

7. Method according to one of the preceding claims, **characterized in that** the distance between the ultrasonic source and the ultrasonic microphone is measured.

8. Method according to one of the preceding claims, **characterized in that** a cepstrum is calculated for the ultrasonic signal.

9. Method according to one of the preceding claims, **characterized in that** the ultrasonic signal is assessed by comparing the calculated cepstrum with cepstra which are available for ultrasonic signals of precisely defined types of electrical partial discharges.

10. Method according to one of the preceding claims, **characterized in that** the ultrasonic signal is assessed in real time.

11. Method according to one of the preceding claims, **characterized in that** ultrasonic sources up to a distance of 200 m are detected and assessed.

12. Ultrasonic measurement device for detecting broadband ultrasound, configured to carry out a method according to one of Claims 1 to 11, having
• a broadband ultrasonic microphone;
• measurement electronics having a library of cepstra for known electrical partial discharges;
• a user interface;
• optionally a distance meter;
wherein the ultrasonic measurement device is configured to detect and assess the acoustic effects of an electrical partial discharge which propagates through air ultrasound;
**characterized in that**
the ultrasonic measurement device is configured to select a frequency range to be evaluated on the basis of a distance between the ultrasonic microphone and a measured ultrasonic source.

13. Ultrasonic measurement device according to Claim 12, **characterized in that** the ultrasonic measurement device also has a concave mirror.

14. Ultrasonic measurement device according to either of Claims 12 and 13, **characterized in that** the ultrasonic measurement device is in the form of a handheld device.

15. Use of the method according to one of Claims 1 to 11 or of the ultrasonic measurement device according to one of Claims 12 to 14 for detecting and assessing electrical faults.

## Revendications

1. Procédé de détection et d'évaluation de sources ultrasonores à l'aide d'un microphone à ultrasons à large bande, les sources ultrasonores représentant des effets acoustiques d'une décharge partielle électrique qui se propagent à travers le son transmis par l'air, **caractérisé en ce que** un signal ultrasonore à large bande d'au moins une source ultrasonore est mesuré ;
au moins une gamme de fréquences du signal ultrasonore est évaluée ; et
le choix de la gamme de fréquences dans laquelle le signal ultrasonore est évalué est effectué en fonction de la distance entre le microphone ultrasonore et la source ultrasonore.

2. Procédé selon la revendication 1, **caractérisé en ce qu'**un signal ultrasonore à large bande est mesuré avec des fréquences de 10 kHz à 100 kHz.

3. Procédé selon l'une des revendications précédentes, **caractérisé en ce que**, pour des distances entre le microphone ultrasonore et la source ultrasonore allant jusqu'à 10 m, une gamme de fréquences du signal ultrasonore est évaluée qui est comprise entre 60 kHz et 100 kHz, de préférence entre 70 kHz et 100 kHz, de manière particulièrement préférée entre 80 kHz et 100 kHz.

4. Procédé selon l'une des revendications précédentes, **caractérisé en ce que**, pour des distances entre le microphone ultrasonore et la source ultrasonore comprises entre 10 m et 100 m, une gamme de fréquence du signal ultrasonore est évaluée qui est comprise entre 20 kHz et 60 kHz, de préférence entre 30 kHz et 60 kHz, de manière particulièrement préférée entre 40 kHz et 60 kHz.

5. Procédé selon l'une des revendications précédentes, **caractérisé en ce que**, pour des distances entre le microphone ultrasonore et la source ultrasonore supérieures à 100 m, une gamme de fréquences du signal ultrasonore est évaluée qui est comprise entre 10 kHz et 40 kHz, de préférence entre 10 kHz et 30 kHz, de manière particulièrement préférée entre 10 kHz et 20 kHz.

6. Procédé selon l'une des revendications précédentes, **caractérisé en ce que** la distance est prise à partir du spectre large bande lui-même.

7. Procédé selon l'une des revendications précédentes, **caractérisé en ce que** la distance entre la source ultrasonore et le microphone ultrasonore est mesurée.

8. Procédé selon l'une des revendications précédentes, **caractérisé en ce qu'**un cepstre est calculé pour le signal ultrasonore.

9. Procédé selon l'une des revendications précédentes, **caractérisé en ce que**
le signal ultrasonore est évalué par comparaison du cepstre calculé à des cepstres disponibles pour les signaux ultrasonores de types bien définis de décharges partielles électriques.

10. Procédé selon l'une des revendications précédentes, **caractérisé en ce que** l'évaluation du signal ultrasonore est effectuée en temps réel.

11. Procédé selon l'une des revendications précédentes, **caractérisé en ce que** les sources ultrasonores sont détectées et évaluées jusqu'à une distance de 200 m.

12. Dispositif de mesure d'ultrasons destiné à la détection d'ultrasons large bande et conçu pour mettre en œuvre un procédé selon l'une des revendications 1 à 11, ledit dispositif comportant
• un microphone à ultrasons large bande ;
• une électronique de mesure, disposant d'une bibliothèque de Cepstra pour les décharges partielles électriques connues ;
• une interface utilisateur ;
• éventuellement un télémètre ;
le dispositif de mesure d'ultrasons étant conçu pour détecter et évaluer les effets acoustiques d'une décharge partielle électrique qui se propage par le biais d'ultrasons transmis par l'air ;
**caractérisé en ce que**
le dispositif de mesure d'ultrasons est conçu pour sélectionner une gamme de fréquences à évaluer en fonction d'une distance du microphone à ultrasons par rapport à une source ultrasonore mesurée.

13. Dispositif de mesure d'ultrasons selon la revendication 12, **caractérisé en ce que** le dispositif de mesure d'ultrasons comprend en outre un miroir concave.

14. Dispositif de mesure d'ultrasons selon l'une des revendications 12 ou 13, **caractérisé en ce que** le dispositif de mesure à ultrasons est réalisé sous la forme d'un dispositif à main.

15. Utilisation du procédé selon l'une des revendications 1 à 11 ou du dispositif de mesure d'ultrasons selon l'une des revendications 12 à 14 pour la détection et l'évaluation de défauts électriques.
